# EUROPEAN PATENT APPLICATION

(11) **EP 1 643 003 A1**
(43) Date of publication of application: **05.04.2006**
(21) Application number: 05292037.8
(22) Date of filing: 30.09.2005
(51) Int. Cl.: C23C 16/448, C23C 16/44, C23C 16/52

(54) **Vaporizer for CVD apparatus**

(30) Priority: 01.10.2004 JP 2004290087
(71) Applicant: Youtec Co., Ltd., Nagareyama-shi, Chiba (JP); Yamoto, Hisayoshi, Nagareyama-shi Chiba (JP)
(72) Inventor: Yamoto, Hisayoshi, Youtec Co., Ltd., Chiba (JP); Koshimae, Shinichi, Youtec Co., Ltd., Chiba (JP)
(74) Representative: Maillet, Alain

(57) **Abstract**

The vaporizer of the solution-vaporization type CVD apparatus comprises: the orifice tube, inside the nozzle (32), dispersing at least one kind of a raw-material solution in a carrier gas in a fine particulate or misty form; at least one path for at least one kind of the raw-material solution, the at least one path supplying at least one kind of the raw-material solution to the orifice tube separately from one another; the path for the carrier gas supplying the carrier gas to the orifice tube separately from the raw-material solution; the vaporizing tube vaporizing at least one kind of the raw-material solution dispersed by the orifice tube; and the orifice connected to the vaporizing tube (31) and the orifice tube, the orifice introducing at least one kind of the raw-material solution dispersed by the orifice tube into the vaporizing member.

## Description

### BACKGROUND OF THE INVENTION

### Field of the Invention

The present invention relates to a solution-vaporization type CVD (Chemical Vapor Deposition) apparatus. In particular, the present invention relates to a solution-vaporization type CVD apparatus which can precisely control a flow rate of a raw-material.

### Description of the Related Art

CVD is a technique to deposit a thin film having various compositions on a semiconductor substrate made from silicon, etc., by allowing gaseous reactants to flow to a reactor chamber and causing a chemical reaction. There is a technical premise that a film deposition by CVD requires a preparation of gaseous reactants. A film formed by CVD, however, has relatively good quality and step coverage, and thus it has been required to apply the CVD technique to fabricate various semiconductors, semiconductor integrated circuits by resolving the above technical premise.

As an example case, fabrication of a ferroelectric memory FeRAM (FRAM: Ferroelectric Random Access Memory) will now be explained. When a fabrication technique for a FeRAM by utilizing a polarization phenomenon of a ferroelectric material such as PZT, SBT was announced, a thin film of a ferroelectric material was formed by, not CVD but solution coating at that time because it was technically difficult to prepare gaseous reactants containing Zr, Sr, Bi, or the like. A ferroelectric thin film (thickness: 400-300 nm) formed by solution coating, however, has poor step coverage. Moreover, when it is thinned (to a thickness: 150-40 nm), the number of pin holes therein is increased, whereby insulation property thereof is decreased.

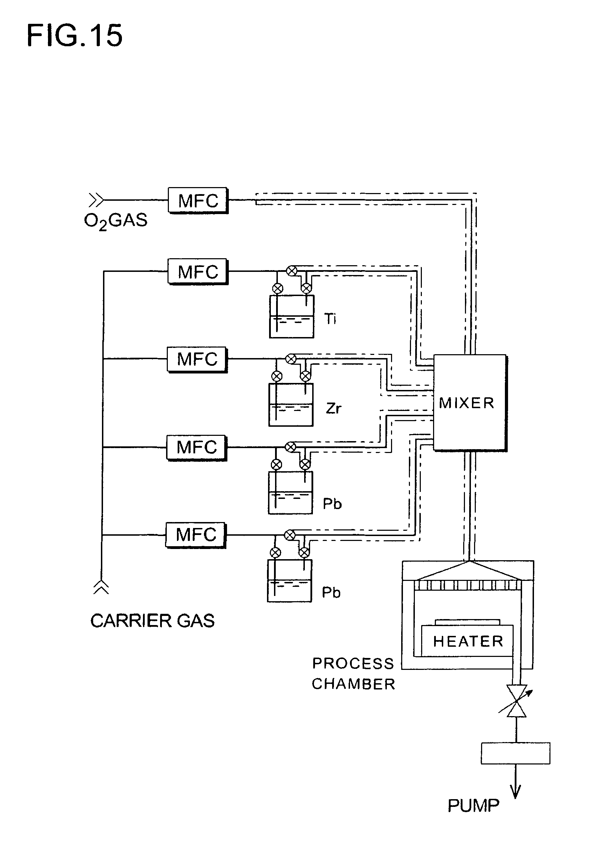

In an effort to put a FeRAM-LSI having a plurality of steps and requiring the thinning of a ferroelectric material (to a thickness: 100-50 nm) into a practical use, an apparatus which forms a high-quality ferroelectric thin film by CVD was proposed. A schematic structure of the apparatus is illustrated in FIG. 15. According to the apparatus, a solid material such as titanium, zircon, zinc or the like is vaporized by sublimation.

In the technique to vaporize a solid chemical by sublimation, however, there are various problems. To be more precise, because a sublimation rate is low when sublimating a solid chemical, it is difficult to increase a flow rate of reactants. Moreover, because of the difficulty in controlling the flow rate of the reactants, a deposition rate of a thin film is low, thus resulting in a poor reproducibility. Further, it is difficult to carry the sublimated reactants up to a reactor chamber, using a pipe heated to, for instance, 250° C.

Based on the above-described problems, inventors of the present invention focused on a technique to form a high-quality thin film of a ferroelectric material SBT not by gasifying with sublimation, but by solution-vaporization CVD (so-called "flash CVD"). Solution-vaporization CVD is a technique that a solid or liquid material having low vapor pressure is dissolved in an organic solvent having high vapor pressure, a solution obtained is instantaneously evaporated and sublimated by a vaporizer heated at high temperature so as to gasify (vaporize) the solution, a reactive gas obtained is introduced into a CVD chamber and a chemical reaction is caused by high-temperature heating or the like so as to deposit a thin film on a substrate to be processed. According to the solution-vaporization CVD technique, a thin film can be deposited at high rate. Moreover, a thin ferroelectric film having good step coverage and electrical property can be deposited.

Japanese Unexamined Patent Publication No. 2000-507649 discloses an example of a vaporizer for a solution-vaporization type CVD apparatus. In this vaporizer, solutions of raw-material compounds are gasified on a heated porous wall member. Accordingly, when a raw-material compound having a low evaporation rate is used, the raw-material compound stays on the porous wall member, thermally decomposed gradually and gasifies, thereby synthesizing a new compound which clogs the porous wall member. Moreover, according to this vaporizer, because a plurality of raw-material solutions are mixed at a predetermined ratio and introduced into a heated vaporizing tube by a pump, as a structural problem, the plurality of raw-materials react with one another in solutions, while a compound having small solubility or sublimation temperature is synthesized, and thus a pipe for the solutions and the porous wall member are clogged. Further, because the raw-material solutions are introduced into an inside of the vaporizing tube heated at high temperature via a thin pipe (outer diameter: 1/16 inch), the thin pipe is heated at high temperature. Consequently, when the pressurized solutions do not flow, solutions staying in the inside of the thin pipe is boiled, while only solvents thereof evaporate, and thus raw-material compounds remaining thereinside causes clogging of the thin pipe. Moreover, a vaporizer disclosed by Japanese Patent Publication No. 3470055 employs a so-called "two-step atomizing", but because a large amount of an evaporation of a solution accompanies the two-step atomizing, a raw-material precipitated may cause clogging of a path or atomizing nozzle.

Moreover, other examples of vaporizers are disclosed by Japanese Unexamined Patent Publication No. 2000-216150 and 2002-105646. Those vaporizers, however, do not form a high-quality SBT thin film in some cases. It will now be explained in detail. As a reactant for synthesizing a SBT thin film, Sr(DPM)₂, BiPh₃, Ta(OEt)₅, Sr[Ta(OEt)₅(OC₂H₄OMe)]₂, Bi(OtAm)₃, Bi(MMP)₃, etc. are used. Particularly, when Sr[Ta(OEt)₅(OC₂H₄OMe)]₂ + Bi(MMP)₃ is used, a high-rate deposition (20-100 nm/min) at 320-420° C of low temperatures can be performed, whereby a high-quality SBT thin film having good step coverage and electrical property can be formed. However, when solutions of Sr[Ta(OEt)₅(OC₂H₄OMe)]₂ and Bi(MMP)₃ are mixed at room temperature, both chemicals react with each other, and a material having small solubility and not easily subliming is synthesized. Accordingly, paths for allowing the solutions to flow therethrough and a leading end of a vaporizing tube thereof may be clogged.

Moreover, in those vaporizers, when Sr[Ta(OEt)₅(OC₂H₄OMe)]₂, Bi(MMP)₃, solutions (for instance, Ethyl CycloHexane:ECH), and a carrier gas (for instance, argon, nitrogen) are sprayed to an upper portion of high-temperature vaporizing tube under reduced-pressure atmosphere (approximately 5 to 30 Torr) so as to be atomized, some of mist adhere to an atomizing nozzle and liquefy. In a solution adhering to the atomizing nozzle, only a solvent (for instance, Ethyl CycloHexane: ECH) is evaporated due to the reduced-pressure atmosphere and a heat radiated from the vaporizing tube, solutes thereof precipitate, and thus the atomizing nozzle is clogged.

Moreover, according to a vaporizer disclosed by Japanese Unexamined Patent Publication No. 2002-105646, because it comprises a relatively compact high-temperature vaporizing box, mist may adhere to a surface of the vaporizing box. Accordingly, it is difficult to atomize at short periods of time, and thus an insufficient atomizing occurs. Due to the insufficient atomizing, a precipitation of dissolved solid solutes (formation of minute particles) occurs, whereby a quality of a thin film to be formed is lowered.

Further, similar vaporizers are disclosed by Japanese Patent Publication No. 2767284 and Japanese Patent Publication No. 3047241. Those vaporizers, however, are for atomizing a liquid raw-material having high vapor pressure such as TEOS, and not for gasifying a solid raw-material such as Bi(MMP)₃. Accordingly, when those vaporizers are used for solution-vaporization CVD, clogging due to a precipitation of a solid material in a solution can be caused. Moreover, a pipe thereof or the like can be clogged when a plurality of solutions are mixed. Further, sprayed mist may adhere to walls of the high-temperature vaporizers, and thus solutes are changed into materials having low vapor pressure.

The problems described above can be summarized as follows. According to the technique to vaporize a solid chemical by sublimation at room temperature and to use the gas as a reactive gas, a deposition rate of a thin film is low and varies. In contrast, according to the solution-vaporization CVD technique, a deposition rate of a thin film is high, but a pipe for a solution or a vaporizer is clogged because of a phenomenon that a chemical reaction is caused in a solution state. Due to the clogging, a CVD apparatus can not be continuously operated for long periods of time.

The present invention has been made to solve the above problems. It is, accordingly, an object of the present invention to provide a solution-vaporization type CVD apparatus which can precisely control a flow rate of a raw-material for CVD.

### SUMMARY OF THE INVENTION

In order to attain the above object, according to a first aspect of the present invention, there is provided a solution-vaporization type CVD apparatus which includes a vaporizer, wherein the vaporizer comprises: an orifice tube dispersing at least one kind of a raw-material solution in a carrier gas in a fine particulate or misty form; at least one path for at least one kind of the raw-material solution, the at least one path supplying at least one kind of the raw-material solution to the orifice tube separately from one another; a path for the carrier gas, the path supplying the carrier gas to the orifice tube separately from the raw-material solution; a vaporizing member vaporizing at least one kind of the raw-material solution dispersed by the orifice tube; and an orifice connected to the vaporizing member and the orifice tube, the orifice introducing at least one kind of the raw-material solution dispersed by the orifice tube into the vaporizing member.

Alternatively, the above-described solution-vaporization type CVD apparatus may further comprise: a monitoring mechanism for monitoring a pressure of the carrier gas; and a cleaning mechanism for cleaning at least one of the orifice tube, the orifice and the vaporizing member in accordance with a result of a monitoring by the monitoring mechanism.

In order to attain the above object, according to a second aspect of the present invention, there is provided a solution-vaporization type CVD apparatus which comprises a vaporizer, a reactor chamber connected to the vaporizer and an evacuating mechanism for evacuating the reactor chamber, wherein the vaporizer comprises: a pipe for a carrier gas, the pipe supplying the pressurized carrier gas; an orifice tube connected to a leading end of the pipe; an orifice connected to a leading end of the orifice tube; at least one pipe for at least one kind of a raw-material solution, the at least one pipe being connected to one side of the orifice tube and supplying at least one kind of the raw-material solution separately supplying from one another; a vaporizing tube connected to the orifice and the reactor chamber; and a heating means for heating the vaporizing tube.

Alternatively, in the above-described solution-vaporization type CVD apparatus, at least one kind of the raw-material solution may be mixed with the carrier gas and dispersed therein in a fine particulate or misty form in an inside of the orifice tube; the raw-material solution dispersed in the fine particulate or misty form may be introduced into the vaporizing tube via the orifice; and the raw-material solution introduced into the vaporizing tube may be heated by the heating means.

In order to attain the above object, according to a third aspect of the present invention, there is provided a solution-vaporization type CVD apparatus which comprises a vaporizer, a reactor chamber connected to the vaporizer and an evacuating mechanism for evacuating the reactor chamber, wherein the vaporizer comprises: a pipe for a carrier gas, the pipe supplying the pressurized carrier gas; a pipe for a raw-material solution, the pipe supplying the raw-material solution; an orifice tube connected to the pipe for the raw-material solution; a dispersing portion connected to the orifice tube and the pipe for the carrier gas, the dispersing portion dispersing the raw-material solution in the carrier gas in a fine particulate or misty form; a vaporizing tube connected to the reactor chamber, the vaporizing tube vaporizing the dispersed raw-material solution; an orifice connected to the vaporizing tube and the dispersing portion, the orifice introducing the dispersed raw-material solution into the vaporizing tube; and a heating means for heating the vaporizing tube.

Alternatively, in the above-described solution-vaporization type CVD apparatus, the orifice may be formed on a flange for atomizing; and the flange may be formed with a convex portion on a surface thereof positioning in the vaporizing tube and provided with a leading end of the orifice.

Moreover, the above-described solution-vaporization type CVD apparatus may further comprise a monitoring mechanism for monitoring a pressure of the carrier gas in the inside of the path for the carrier gas: and a cleaning mechanism for cleaning at least one of the orifice tube, the orifice and the vaporizing tube by supplying a solution thereto in accordance with a monitoring result of the monitoring mechanism.

Further, the above-described solution-vaporization type CVD apparatus may further comprise a cleaning mechanism for cleaning the convex portion of the flange with the carrier gas and a solution.

Still further, in the above-described solution-vaporization type CVD apparatus, a leading end of the vaporizing tube may be formed in a spherical or semispherical shape; the orifice may be connected to the leading end of the vaporizing tube; and the heating means may extend up to an end of the leading end of the vaporizing tube.

Moreover, the above-described solution-vaporization type CVD apparatus may further comprise: a mass-flow controller for controlling a flow rate of the carrier gas or the raw-material solution; and a cooling mechanism provided adjacent to the vaporizing tube, the cooling mechanism cooling down the mass-flow controller.

Further, in the above-described solution-vaporization type CVD apparatus, the other end of the vaporizing tube may be connected to a first pipe via a vent valve; the first pipe may be connected to the evacuating mechanism via a second pipe; the vaporizing tube may be connected to the reactor chamber via a gate valve; the reactor chamber may be connected to a main vacuum valve via a third pipe; and the main vacuum valve may be connected to the second pipe.

Still further, the solution-vaporization type CVD apparatus may further comprise a pressure adjustment valve in between the third pipe and the reactor chamber.

Moreover, in the above-described solution-vaporization type CVD apparatus, the other end of the vaporizing tube may be connected to the reactor chamber; the reactor chamber may be connected to one end of a first pipe via a pressure adjustment valve; the other end of the first pipe may be connected to one end of a second pipe via a main vacuum valve; and the other end of the second pipe may be connected to the evacuating mechanism.

By employing the above-described structures, the solution-vaporization type CVD apparatus according to the present invention can precisely control a flow rate of a raw-material for long periods of time.

### BRIEF DESCRIPTION OF THE DRAWINGS

These objects, other objects and advantages of the present invention will be more apparent upon reading of the following detailed description and the accompanying drawings in which:
FIG. 1 is a schematic view illustrating a structure of a vaporizer according to a first embodiment of the present invention;
FIG. 2 is a schematic view illustrating a structure of a vaporizer according to a second embodiment of the present invention;
FIG. 3 is a schematic view illustrating a structure of a vaporizer according to a third embodiment of the present invention;
FIGs. 4A and 4B are schematic views each illustrating a structure of a vaporizer according to a fourth embodiment of the present invention;
FIGs. 5A and 5B are schematic views each illustrating a structure of a comparative example with respect to the vaporizer of FIGs. 4A and 4B;
FIG. 6 is a schematic view illustrating a structure of a vaporizer according to a fifth embodiment of the present invention;
FIG. 7 is a schematic view illustrating a structure of a vaporizer according to a sixth embodiment of the present invention;
FIG. 8 is a schematic view illustrating a structure of a vaporizer according to a seventh embodiment of the present invention;
FIG. 9 is an enlarged view illustrating a base end of a vaporizer, an adjacent portion thereof, a tip of a nozzle and an adjacent portion thereof;
FIG. 10 is a schematic view illustrating a structure of a vaporizer according to an eighth embodiment of the present invention;
FIG. 11 is a schematic view illustrating a structure of a CVD apparatus according to a ninth embodiment of the present invention;
FIG. 12 is a schematic view illustrating a structure of a CVD apparatus according to a tenth embodiment of the present invention;
FIG. 13 is a schematic view illustrating a structure of a CVD apparatus according to an eleventh embodiment of the present invention;
FIG. 14 is a schematic view illustrating a structure of a CVD apparatus according to a twelfth embodiment of the present invention; and
FIG. 15 is a view illustrating an example of a conventional CVD apparatus for forming a ferroelectric thin film.

### DETAILED DESCRIPTION OF THE PREFERRED EMBODIMENTS

Preferred embodiments of the present invention will now be described with reference to the accompanying drawings.

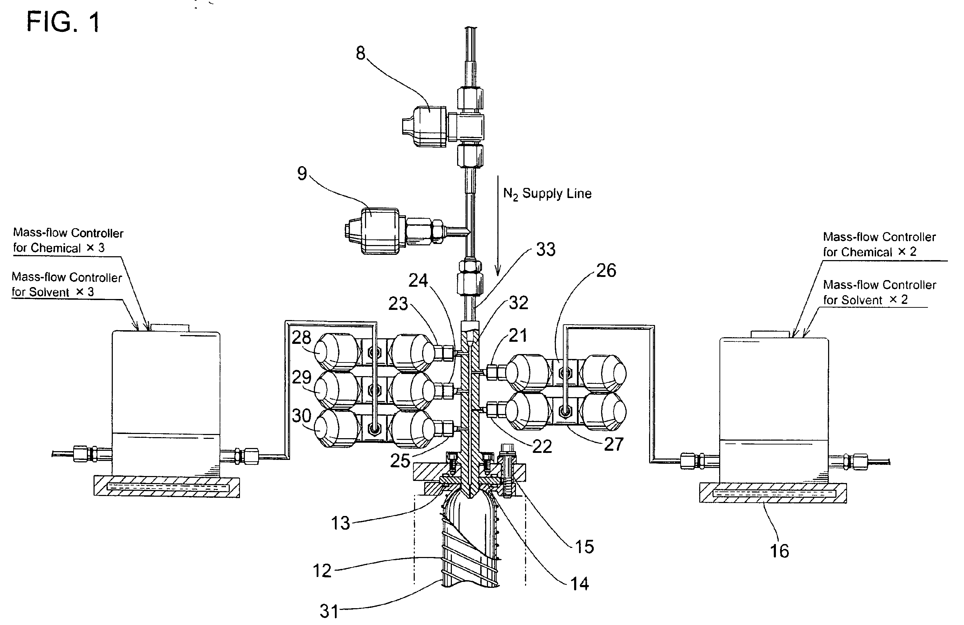

FIG. 1 schematically illustrates a structure of a vaporizer according to a first embodiment of the present invention.

The vaporizer of this embodiment vaporizes solutions made by dissolving solid or liquid organic metallic compounds in solvents at room temperature, and supplies a reactive gas obtained by the vaporization to a reactor chamber of a solution-vaporization type CVD apparatus. The vaporizer comprises a solution-supplying system including first to fifth pipes 21 to 25 for raw-material solutions.

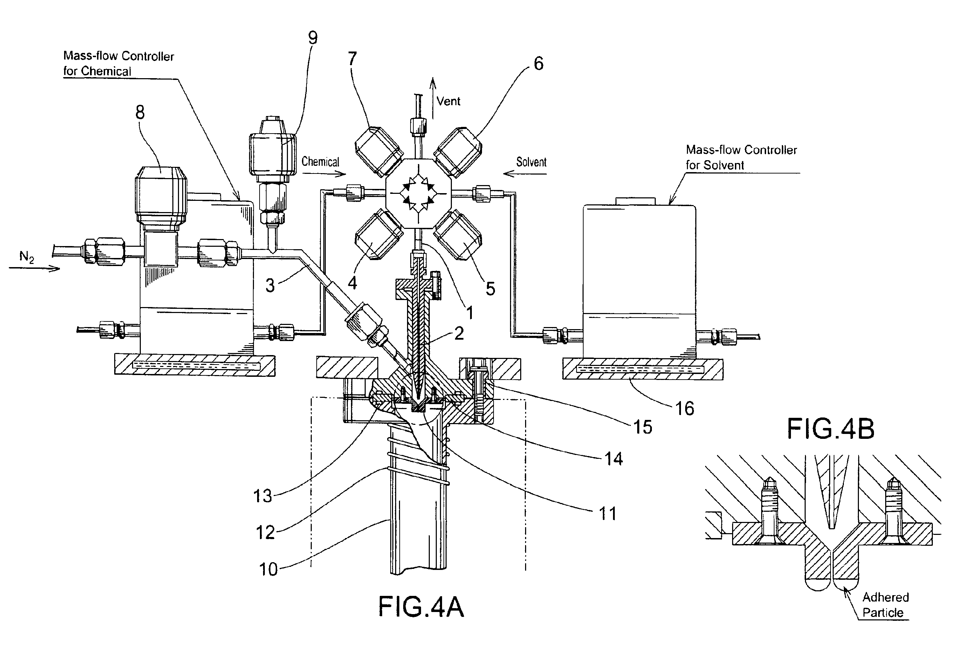

A base end of the first pipe 21 is connected to a first supplying mechanism (not illustrated) for supplying a raw-material solution (chemical) and a solvent. The first supplying mechanism has a chemical-supplying source for supplying the chemical (for instance, Sr[Ta(OEt)₅(OC₂H₄OMe)]₂), and a solvent-supplying source for supplying the solvent (for instance, Ethyl CycloHexane: ECH). A first block valve 26 and a mass-flow controller (not illustrated) are provided in between the chemical-supplying source and the first pipe 21. Moreover, the first block valve 26 and a mass-flow controller (not illustrated) are provided in between the solvent-supplying source and the first pipe 21. The solvent and the chemical flow into (mix with) each other at the outlets of the first block valve 26 in between the solvent-supplying source (solution-supplying source) and the first pipe 21. The block valve 26 is one reducing a dead space of a path of the flow. As illustrated in FIG. 4A, etc., the block valve 26 employs a structure that it has two inlets for fluids and two outlets thereof. The inlets thereof are connected to the chemical-supplying source and the solvent-supplying source. In contrast, the outlets thereof are connected to a vent (not illustrated) and the first pipe 21.

Each of the second to fifth pipes 22 to 25 for raw-material solutions employs a similar structure to that of the first pipe 21.

In more detail, the base ends of the second to fifth pipes 22 to 25 are connected to the second to fifth supplying mechanisms for supplying chemicals and solvents, respectively.

The second supplying mechanism has a chemical-supplying-source for supplying the chemical (for instance, Bi(MMP)₃), and a solvent-supplying-source for supplying the solvent. A second block valve 27 and a mass-flow controller (not illustrated) are provided in between the second pipe 22 and the corresponding chemical-supplying source. Moreover, the second block valve 27 and a mass-flow controller (not illustrated) are provided in between the second pipe 22 and the corresponding solvent-supplying source. The solvent and the chemical flow into (mix with) each other in between the solvent-supplying source (solution-supplying source) and the second pipe 2.

Likewise, the third to fifth supplying mechanisms have chemical-supplying sources and solvent-supplying sources, respectively. Third to fifth block valves 28 to 30 and mass-flow controllers (not illustrated) are provided in between the third to fifth pipes 23 to 25 and the corresponding chemical-supplying sources. Moreover, the third to fifth block valves 28 to 30 and mass-flow controllers (not illustrated) are provided in between the third to fifth pipes 23 to 25 and the corresponding solvent-supplying sources. The solvents and the chemicals flow into (mix with) one another in between the third to fifth pipes 23 to 25 and the corresponding solvent-supplying sources (solution-supplying sources).

Leading ends of the first to fifth pipes 21 to 25 are connected to an orifice tube, respectively, while a leading end of the orifice tube is connected to a base end side of an orifice. The orifice and orifice tube are provided in the inside of a nozzle 32. In the inside of the orifice tube, first to fifth raw-material solutions flowing out from the leading ends of the first to fifth pipes 21 to 25 and a carrier gas such as nitrogen gas flowing in via a pipe 33 for the carrier gas are mixed, and the raw-material solutions are dispersed in the carrier gas in fine particle or misty forms.

A base end of the orifice tube is connected to the pipe 33 for the carrier gas. An internal diameter of the pipe 33 is smaller than that of the orifice tube. For instance, the internal diameter of the orifice tube is about 1 mm, while a length thereof is about 100 mm. Moreover, an internal diameter of the orifice is, for instance, about 0.2 to 0.7 mm.

A base end of the pipe 33 is connected to a supplying mechanism for supplying a nitrogen gas. A N₂-supplying valve 8 and a mass-flow controller (not illustrated) are provided in between the nitrogen-gas-supplying mechanism and the pipe 33. The pipe 33 is provided with a pressure transducer 9. The pressure transducer 9 accurately measures a pressure of the carrier gas and a fluctuation thereof, records and constantly observes those. The pressure transducer 9 sends an output signal having a signal level corresponding to a pressure level of the carrier gas to a non-illustrated controller. Based on the signal level of the output signal, the pressure level of the carrier gas can be displayed on a non-illustrated control-monitor and thus monitored.

A leading end of the orifice (a leading end of an opening of the nozzle 32) is connected to a base end of a hemispherical type vaporizing tube 31. A heater 12 is provided around the vaporizing tube 31, while the vaporizing tube 31 is heated to, for instance, 270° C by the heater 12. The base end side of the vaporizing tube 31 is air-tightly sealed by an O-ring 13. Moreover, a thermal insulator 14 is provided in between the base end of the vaporizing tube 31 and the orifice tube. Because of the thermal insulator 14, a heat transfer from the vaporizing tube 31 to the orifice tube can be suppressed. Moreover, the base end of the vaporizing tube 31 is connected to a water-cooling plate 16 via a thermal insulator 15, while a mass-flow controller is provided on the water-cooling plate 16. The water-cooling plate 16 cools down the mass-flow controller by allowing water to circulate thereinside. Without the water-cooling plate 16, the mass-flow controller is to be heated to 45 to 50° C due to a heat generated from the heated vaporizing tube 31, and thus an accuracy of a flow control is lowered. However, by providing the mass-flow controller on the water-cooling plate 16 and water-cooling it by the water-cooling plate 16, a temperature rise of the mass-flow controller can be prevented, and thus the accuracy of the flow control can be improved. Meanwhile, a leading end of the vaporizing tube 31 is connected to a non-illustrated reactor chamber.

It is preferable that mist sprayed from the orifice do not soak a wall of the vaporizing tube, because an evaporation area is significantly decreased when the wall thereof is soaked. Accordingly, the vaporizer may preferably employ a structure such that the wall thereof is kept completely clean. In order to easily asses a degree of contamination with respect to the wall, it is preferable that the wall be finished like a mirror.

Next, operations of the above vaporizer for CVD will now be explained in detail.

First, the N₂-supplying valve 8 is opened so as to supply the carrier gas to the pipe 33. The carrier gas is introduced into the vaporizing tube 31 via the orifice tube and the orifice. When the carrier gas is introduced, a flow rate of the carrier gas is under a control by the mass-flow controller. In this embodiment, the nitrogen gas is used as the carrier gas, but other gases such as helium, hydrogen, etc., can be used. The carrier gas is one for atomizing the raw-material solution, heating the mist in the inside of the heated vaporizing tube 31 so as to gasify it, and causing a chemical reaction on a substrate to be processed in a reactor chamber so as to create an appropriate flow current when depositing a thin film. Accordingly, it is preferable to use nitrogen, helium or hydrogen gas having good thermal conductivity. Moreover, a pressure of the carrier gas after its flow rate is controlled varies depending on the flow rate thereof (approximately 0.5 to 3.0 L/min), flow rates of solvents and a size of an atomizing nozzle (the orifice), but it is preferable that the size of the atomizing nozzle be changed so as to control the pressure of the carrier gas to be 500 to 1000 Torr.

Next, the block valves 26 to 30 are opened so as to supply the first to fifth raw-material solutions from the respective first to fifth supplying mechanisms to the first to fifth pipes at predetermined pressures. Each of the supplied raw-material solutions are introduced into the orifice tube. While introduced, the first to fifth raw-material solutions are under flow rate controls by the mass-flow controllers, respectively. The orifice tube mixes the first to fifth raw-material solutions and the carrier gas, while it disperses the first to fifth raw-material solutions in the carrier gas in fine particulate or misty forms. The dispersed raw-material solutions are then sprayed into the vaporizing tube 31 via the orifice at a high speed (230 m/sec. to 35 km/sec.) In the vaporizing tube 31, the first and second raw-material solutions dispersed in misty forms are instantaneously heated to approximately 270° C by the heater 12. Meanwhile, it is preferable that the first to fifth raw-material solutions be dispersed in fine particulate or misty forms within a single second (more preferably, within 0.1 to 0.002 sec.) immediately after being mixed by the orifice tube.

There is a large difference between a pressure of the inside of the orifice tube and that of the inside of the vaporizing tube 31. The pressure of the inside of the vaporizing tube 31 is, for instance, approximately 10Torr, while that of the inside of the orifice tube is, for instance, 500-1000 Torr. By setting the pressure-difference like this, the carrier gas is ejected toward the vaporizing tube 31 at a high speed (for instance, 230 m/sec. to 35 km/sec.), and expands in accordance with the pressure-difference. Accordingly, an atomized droplet of the mist can be obtained (diameter: less than or equal to 1µ m), whereby an evaporation area and an evaporation ratio can be intended to be increased. When a size of the atomized droplet is reduced by one digit, the evaporation area can be enlarged by one digit. Moreover, by reducing the pressure of the inside of the vaporizing tube 31, sublimation temperatures of chemicals contained in the first to fifth raw-material solutions can be dropped, and thus the raw-material solutions (with the chemicals) can be vaporized by the heat from the heater 12. Further, the first to fifth raw-material solutions are turned to be fine mist by the high-speed flow of the carrier gas immediately after dispersed by the orifice tube, and thus they are easily vaporized instantaneously in the vaporizing tube 31. Still further, a phenomenon that only the solvents vaporize can be suppressed. Meanwhile, because of the above-described reason, it is preferable to design an angle of the atomizing nozzle and a size of the vaporizing tube so that the mist sprayed from the atomizing nozzle does not collide with the wall of the vaporizing tube 31.

Thus way, a source gas is produced by vaporizing the first to fifth raw-material solutions in the vaporizer for CVD. The source gas is introduced into a reactor chamber via the vaporizing tube 31, while a thin film is deposited on a substrate to be processed in the reactor chamber.

Moreover, instead of the above-described deposition process, the following deposition process can be adopted.

First, the first and second raw-material solutions and the carrier gas are allowed to flow into the reactor chamber via the vaporizing tube 31 for an appropriate period so as to form a first thin film on a substrate to be processed. Next, valves for the first and second raw-material solutions are changed to be as exhausts so as to terminate the deposition of the first thin film. The third and fourth raw-material solutions and the carrier gas are supplied to the vaporizing tube 31 at predetermined flow rates. When a sum of the flow rate of the third and fourth raw-material solutions (that is, volume thereof) exceeds one to five times of capacities of pipes from the block valves to the orifice, the third and fourth raw-material solutions and the carrier gas are allowed to flow into the reactor chamber via the vaporizing tube 31 for a predetermined period so as to form a second thin film on the substrate. Accordingly, two kinds of thin films having different compositions can be successively formed.

Moreover, by repeating the above-described process three or more times, three or more kinds of thin films can be successively deposited. Meanwhile, when supplying another kind of raw-material solution to the reactor chamber, a temperature of the substrate and a pressure when reacting may be appropriately changed.

As mentioned above, while vaporizing the raw-material solutions, the pressure of the carrier gas is constantly monitored by the pressure transducer 9. When the vaporizer for CVD is continuously operated, solutes of the raw-material solutions gradually precipitate on at least either one of the orifice tube or the orifice (atomizing nozzle), and thus the orifice is gradually clogged.

This phenomenon will now be explained in detail. In the vaporizer for CVD, the raw-material solutions and the carrier gas are sprayed to a high-temperature upper portion of the vaporizing tube 31 under reduced-pressure atmosphere (approximately 5-20 Torr) so as to be atomized. When sprayed, the mist may partially adhere to the orifice (atomizing nozzle) and liquefy. In the raw-material solutions adhering to the atomizing nozzle, only solvents having large vapor pressure are evaporated due to the reduced-pressure atmosphere and the heat radiated from the vaporizing tube 31 in a high-temperature condition, the solid materials as the solutes precipitate, and thus the atomizing nozzle is clogged. Meanwhile, because a tip of the nozzle 32 provided with the orifice is formed in a convex shape, a time until the orifice is clogged can be extended like the fifth embodiment. For instance, by setting an apical angle of the leading end of the orifice at 45 to 135 degree, preferably at 30 to 45 degree, the phenomenon that the precipitated solid materials clog the orifice can be suppressed. In contrast, when the leading end of the orifice is formed in a plane or obtuse shape, a little amount of the precipitated solid materials can clog the orifice at short periods of time.

As the clogging progressing, the pressure of the carrier gas in the inside of the pipe 33 increases. After the controller receives an output signal from the pressure transducer 9 and notified that the pressure of the carrier gas exceeds a predetermined value (for instance, 200K Pa), the supply of the raw-material solutions are terminated, but the solvents are allowed to flow therethrough. Or, an outlet of the vaporizing tube 31 is changed from a reactor to an exhaust side, only the solvents and the carrier gas are supplied to the orifice tube and the orifice so as to clean them. When cleaning, an effectiveness of the cleaning can be improved by increasing amounts of the flows of the solvents at twice to ten times as much as those of the solutions. Moreover, it is preferable that the solvents be allowed to flow for one to three minutes. Accordingly, the atomizing nozzle sprays the solvents, while the solutes precipitating thereon are re-dissolved by the solvents, whereby they are eliminated therefrom. Meanwhile, it is preferable that the solvents for cleaning be one or a mixture of those selected from a group consisting of ethyl cyclohexane, n-hexane, benzene, toluene, THF, octane, decane or butyl acetate. In this embodiment, a preferable solvent is one such that: vapor pressure thereof is low; the raw-materials are allowed to easily solute; it does not react with the raw-materials; it bums under oxygen atmosphere but not allow carbon to remain; and it easily decomposes under hydrogen atmosphere but not allow carbon to remain. Accordingly, as the solvent, ethyl cyclohexane is suitable rather than butyl acetate, THF, n-hexane and tricloethylene toluene.

Meanwhile, in this embodiment, the solvents for the cleaning are supplied from the supplying mechanisms, but the supply thereof is not limited to this. For instance, a solvent supplying mechanism for the cleaning may be separately provided, while a solvent for the cleaning may be supplied from this solvent supplying mechanism. Moreover, it is preferable that a processed substrate be taken out from the reactor chamber prior to the cleaning, while a new substrate to be processed be put into the reactor chamber after the cleaning. When the solutes precipitate and adhere to the orifice (atomizing nozzle), lowering the sublimation rate of a CVD thin film and a change of the composition thereof are observed. As a result, a reproducibility of the CVD-thin-film deposition process is lowered, whereby the quality thereof and the yield thereof are lowered. To prevent those lowering, it is preferable that the cleaning be performed prior to the detection of the clogging. For instance, the reproducibility can be improved by cleaning the vaporizing tube 31 or the like during a waiting time with a couple of minutes from a point that a substrate is processed and another point that the CVD-thin-film-deposition process is performed with the next substrate being put into the reactor chamber.

During the above cleaning process, the pressure of the carrier gas in the pipe 33 is also monitored by the pressure transducer 9. Accordingly, a condition of the clogging with respect to the orifice can be monitored. As the cleaning process continued, the clogging of the orifice (atomizing nozzle) can be gradually resolved since the precipitated solutes are dissolved. Accordingly, the pressure of the carrier gas is gradually lowered. After the controller is notified by pressure transducer 9 that the pressure of the carrier gas is turned to be less than or equal to the predetermined value (for instance, 100K Pa), the supply of the raw-material solutions are restarted..

Meanwhile, when the flow rates of the raw-material solutions during the CVD process is X cc/min., it is preferable that the capacities of the pipes from the first to fifth block valves 26 to 30 to the leading ends of the first to fifth pipes 21 to 25 be less than or equal to 8X cc, more preferably, less than or equal to 2X cc, and further preferably, less than or equal to X cc. This will be applied to the following embodiments.

Moreover, in this embodiment, the timing for the cleaning in order to resolve the clogging of the atomizing nozzle with the solvents is determined by monitoring the pressure of the carrier gas with the pressure transducer 9, but not limited to this. For instance, the cleaning may be performed by allowing the solutions and carrier gas to flow after a predetermined time elapses so as to eliminate the precipitated solutes.

According to this embodiment, the orifice (atomizing nozzle) is cleaned by the solvents before it is completely clogged, and thus it can be brought into an original condition. Therefore, the vaporizer for CVD can be used for significantly long periods of time by performing the cleaning process during the operation thereof. It takes approximately 10 hours for disassembling the clogged vaporizer, cleaning and reassembling it. The above-described cleaning process, however, can be finished within a couple of minutes, and thus the operation time of the vaporizer can be considerably extended, while a production cost for a semiconductor device or the like can be considerably reduced.

As mentioned above, even if the pressure transducer 9 is provided for monitoring the clogging, the cleaning process is required, and thus the vaporizer can not be continuously operated completely. However, a solution-vaporization CVD apparatus which can continuously deposit over several hundred hours can be embodied when one reactor chamber is equipped with a plurality of vaporizers each having the cleaning mechanism. To be more precise, for instance, a reactor chamber is equipped with 12 vaporizers each having the cleaning mechanism, ten vaporizers among them are operated, while two vaporizers among them are sequentially cleaned constantly during the operation of the solution-vaporization CVD apparatus. By employing this structure, the continuous operation of the solution-vaporization CVD apparatus over several hundred hours can be carried out, while a deposition rate of a thin film can be remarkably improved. The solution-vaporization CVD apparatus, which sequentially cleans a plurality of the vaporizers so as to deposit continuously, is suitable for a case that, for instance, a superconductive oxide thin film of YBCO with a thickness of 10µm is formed on a long-tape-shaped substrate.

According to this embodiment, the first to fifth raw-material solutions can be supplied to the orifice tube separately from one another by the first to fifth pipes 21 to 25. To be more precise, more than two kinds of the chemicals, such as (Sr[Ta(OEt)₅(OEtOMe)]₂) and (Bi(MMP)₃ can be separately supplied to the orifice tube without mixing them before they reach the orifice tube, whereby a chemical reaction of the raw-material solutions in solution states can be prevented, while the clogging in the inside of the pipes for the raw-material solutions can be prevented. Consequently, the continuous operation time of the vaporizer for CVD can be extended.

Moreover, according to this embodiment, since the carrier gas pressurized in the pipe 33 for the carrier gas is introduced to the orifice tube by allowing it to flow at high speed (for instance, 200 ml/min. to 2 L/min. at 500 to 1000 Torr), temperature rises of the raw-material solutions in the orifice tube can be suppressed. Accordingly, it is suppressed that only the solvents in the raw-material solutions evaporate, whereby phenomenon such that viscosities of the raw-material solutions rise or a precipitation occurs beyond solubility thereof due to concentrations of the raw-material solutions can be suppressed. Therefore, the continuous operation time of the vaporizer for CVD can be extended.

Further, according to this embodiment, the raw-material solutions are dispersed by the orifice tube, while the dispersed raw-material solutions in fine particulate or misty forms are sprayed by the orifice (atomizing nozzle) and heated in the inside of the vaporizing tube 31 so as to be vaporized (gasified) instantaneously. Accordingly, the vaporization of the solvents only in the raw-material solutions can be suppressed, whereby the clogging of the orifice can be suppressed. Therefore, the continuous operation time of the vaporizer for CVD can be extended.

As described, according to this embodiment, the clogging of the dispersing portion (orifice tube), orifice and vaporizing tube 31 can be suppressed, and thus the vaporizer can be stably and continuously used for long periods of time. Therefore, a thin film of ferroelectric material such as PZT, SBT, a metallic thin film of Cu, Ta, Ru, etc., a thin film of superconductive material such as YBCO, a thin film of ZnO used as transparent electrode, or the like can be deposited with a good reproducibility and controllability, whereby the vaporizer and a solution-vaporization type CVD apparatus equipping the same can be of high-performance.

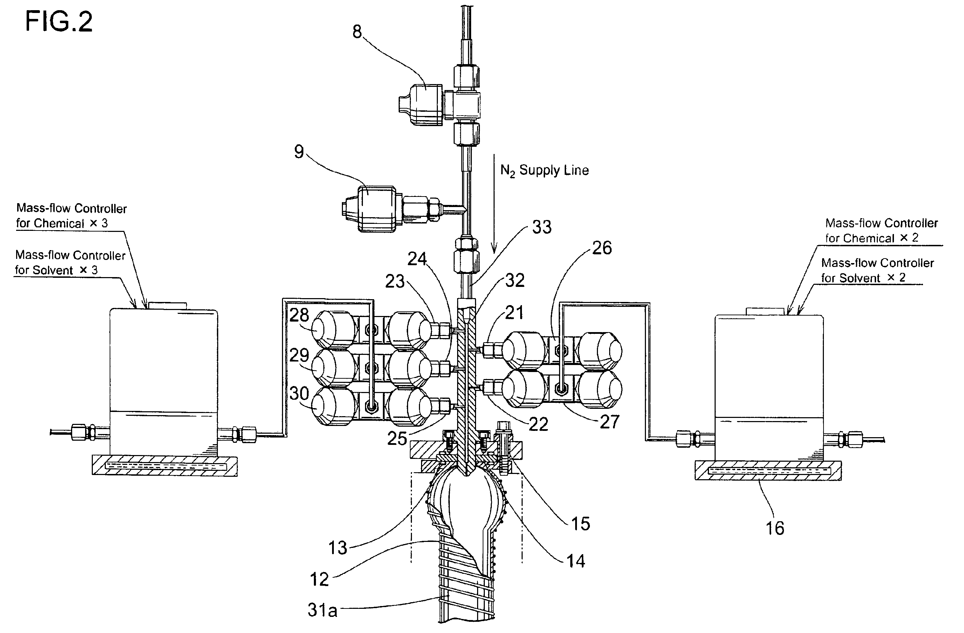

FIG. 2 schematically illustrates a structure of a vaporizer according to a second embodiment of the present invention. The same structure portions as those illustrated in FIG. 1A will be denoted by the same reference numbers, respectively, while detailed explanations thereof will be omitted. Likewise, in the following embodiments, detailed explanations thereof will be omitted for the same reason.

In this embodiment, a base end of a vaporizing tube 31 a is formed in a spherical shape. Accordingly, the base end thereof can be uniformly heated.

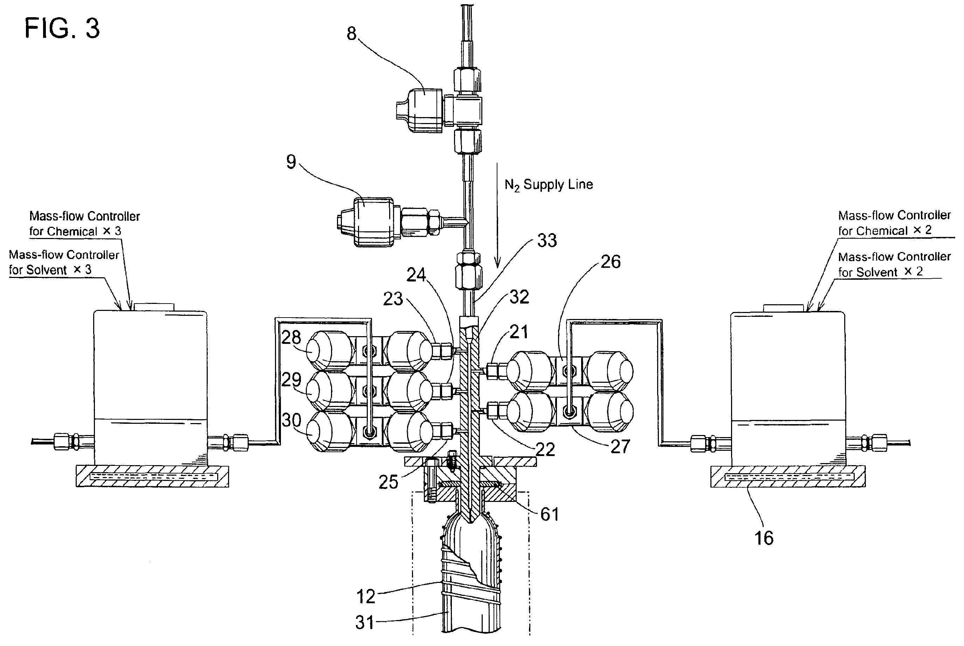

FIG. 3 schematically illustrates a structure of a vaporizer according to a third embodiment of the present invention.

In the third embodiment, a metal seal 61 is provided instead of the thermal insulator 14 (daiflon packing, etc.) illustrated in FIG. 1. The metal seal 61 is one which can endure ultrahigh vacuum, while it has high mechanical strength and thermostability, whereby a heating temperature of a vaporizing tube 31 can be more than or equal to 300 °C. However, because a temperature of an orifice tube is also rose, clogging of an orifice due to precipitations of solid materials is more likely to occur. In this case, the number of the cleaning may be increased appropriately so as to suppress the clogging.

FIGs. 4A and 4B schematically illustrate a structure of a vaporizer according to a fourth embodiment of the present invention. The vaporizer of this embodiment comprises a solution-supplying system, while the solution-supplying system comprises a pipe 1 for a plurality of raw-material solutions. A leading end of the pipe 1 is connected to a base end of a pipe having a smaller diameter, while a leading end of the pipe having a smaller diameter is provided with a nozzle 2. The leading end of the pipe having a smaller diameter extends to a discharging end of the nozzle 2. A diameter of the pipe having a smaller diameter is smaller than that of the pipe 1. To be more precise, the diameter of the pipe having a smaller diameter is, for instance, about 1mm, while a length thereof is about 10mm.

A base end of the pipe 1 is connected to a supplying mechanism for supplying the raw-material solutions (chemicals) and solvents. The supplying mechanism has a chemical-supplying source for supplying the chemicals (for instance, the mixed raw-material solutions of: Pb(DPM) 2:0.05 mol/L; Zr(IBPM) 2:0.03 mol/L; Ti(OiPr)2(DPM)2:0.03 mol/L; and Nb(DPM)4:0.01 mol/L), and a solvent-supplying source for supplying the solvents. A block valve 4 and a mass-flow controller are provided in between the chemical-supplying source and the first pipe 1. Moreover, a block valve 5 and a mass-flow controller are provided in between the solvent-supplying source and the pipe 1. The solvents and the chemicals flow into (mix with) one another in between the solvent-supplying source and the pipe 1. The solvent-supplying source is connected to a pipe for a vent via a block valve 6, while the solution-supplying source is connected to the pipe via a block valve 7.

An inlet introducing a carrier gas is formed on a portion of an outward of the nozzle 2 adjacent to an orifice with respect to the tip of the nozzle 2. The inlet is connected to a leading end of a pipe 3 for the carrier gas. A base end of the pipe 3 is connected to a supplying mechanism for supplying a nitrogen gas. A N₂-supplying valve 8 and a mass-flow controller (not illustrated) are provided in between the supplying mechanism and the pipe 3. Moreover, like the first embodiment, the pipe 3 for the carrier gas is provided with the pressure transducer 9.

A dispersing portion is defined adjacent to and around the tip of the nozzle 2, while it is connected to the inlet. Moreover, the dispersing portion is connected to a base end of a straight vaporizing tube 10 via an orifice, while the orifice is formed on a flange 11 for atomization. A surface of the flange 11, which is located adjacent to the vaporization tube 10 and has a tip of the orifice, is provided with a portion formed in a plane shape. The tip of the nozzle 2 is spaced away from the orifice, while an inside of the vaporizing tube 10 is connected to the dispersing portion via the orifice. The dispersing portion mixes the raw-material solutions flowing out from the tip of the nozzle 2 and the nitrogen gas flowing out from the inlet via the pipe 3.

The heater 12 is provided around the vaporizing tube 10, while the vaporizing tube 10 is heated to, for instance, 270° C by the heater 12. The base end side of the vaporizing tube 10 is air-tightly sealed by the O-ring 13. Moreover, the thermal insulator 14 is provided in between the base end of the vaporizing tube 10 and the dispersing portion, flange 11 for atomization. Because of the thermal insulator 14, a heat transfer from the vaporizing tube 10 to the flange 11 and the dispersing portion can be suppressed. Moreover, the base end of the vaporizing tube 10 is provided with the thermal insulator 15. The water-cooling plate 16 is provided in a manner spaced away from the vaporizing tube 10, while a mass-flow controller is provided on the water-cooling plate 16. Meanwhile, a leading end of the vaporizing tube 10 is connected to a non-illustrated reactor chamber.

Next, operations of the above vaporizer for CVD will now be explained in detail.

First, the block valve 4 is opened with the block valves 5, 6, and 7 closed so as to supply the raw-material solutions to the pipe 1 at a predetermined pressure. The raw-material solutions are ones made by dissolving solid compounds or the like in the solvents while a flow rate thereof is under a control by the mass-flow controller. Moreover, the N₂-supplying valve 8 is opened so as to supply the carrier gas to the pipe 3. A flow rate thereof is under a control by the mass-flow controller. The carrier gas is, for instance, a nitrogen gas.

The raw-material solutions are then introduced into the dispersing portion via the pipe 1, while the carrier gas is introduced thereinto via the pipe 3. The dispersing portion mixes the raw-material solutions and the carrier gas. It is preferable that the raw-material solutions be dispersed in fine particulate or misty forms within a single second (more preferably, within 0.1 sec.) immediately after being mixed by the dispersing portion.

The raw-material solutions dispersed in the carrier gas by the dispersing portion are introduced into the vaporizing tube 10 via the orifice. In the vaporizing tube 10, the raw-material solutions dispersed in misty forms are instantaneously heated to approximately 270° C by the heater 12.

Like the orifice tube and vaporizing tube 31 of the first embodiment, there is a large difference between a pressure of the inside of the dispersing portion and that of the inside of the vaporizing tube 10. The inside of the vaporizing portion 10 is in a reduced pressure condition of 5 to 30 Torr, while that of the inside of the orifice tube is, for instance, 500 to 1000 Torr. By setting the pressure-difference like this, the carrier gas is ejected toward the vaporizing tube 10 at an ultrahigh speed, and expands in accordance with the pressure-difference. Accordingly, sublimation temperatures of solid chemicals contained in the raw-material solutions are dropped, and thus the raw-material solutions (with the chemicals) can be vaporized by the heat from the heater 12. Moreover, the raw-material solutions are turned to be fine mist by the high-speed flow of the carrier gas immediately after dispersed, and thus they are more likely to vaporize instantaneously.

Thus way, a source gas is produced by vaporizing the raw-material solutions in the vaporizer for CVD. The source gas is introduced into the reactor chamber via the vaporizing tube 10, while a thin film is deposited on a substrate to be processed in the reactor chamber.

While vaporizing the raw-material solutions, the pressure of the carrier gas is constantly monitored by the pressure transducer 9. As explained in the first embodiment, when the vaporizer for CVD is continuously operated, the orifice (atomizing nozzle) is gradually clogged. Since the detail of this phenomenon is explained in the first embodiment, the detailed explanation thereof will be omitted in this embodiment.

As the clogging progressing, and after the controller receives an output signal from the pressure transducer 9 and notified that the pressure of the carrier gas exceeds a predetermined value (for instance, 200K Pa), the supply of the chemicals is terminated by closing the block valve 4, while the block valve 5 is opened so as to allow the solvents only to flow. Or, an outlet of the vaporizing tube 10 is changed from a reactor to an exhaust side (not illustrated), only the solvents and the carrier gas are supplied to the pipes 1 and 3 for a cleaning. Accordingly, the atomizing nozzle sprays the solvents, while the solutes precipitating thereon are re-dissolved by the solvents, whereby they are eliminated therefrom. Meanwhile, like the first embodiment, a solvent supplying mechanism for the cleaning may be separately provided, while a solvent for the cleaning may be supplied from this solvent supplying mechanism. Detailed explanations of the cleaning and the advantages thereof are explained in the first embodiment, and thus omitted in this embodiment.

By the cleaning, the clogging of the orifice (atomizing nozzle) can be gradually resolved. Accordingly, the pressure of the carrier gas is gradually lowered. After the controller is notified by the pressure transducer 9 that the pressure of the carrier gas is turned to be less than or equal to the predetermined value (for instance, 100K Pa), the block valve 4 is opened again so as to restart the supply of the raw-material solutions and the vaporization thereof.

In this embodiment, the timing for the cleaning in order to resolve the clogging of the atomizing nozzle with the solvents is determined by monitoring the pressure of the carrier gas with the pressure transducer 9, but not limited to this. For instance, the cleaning may be performed by allowing the solutions and carrier gas to flow after a predetermined time elapses so as to eliminate the precipitated solutes.

As described, according to this embodiment, the vaporizer introduces the raw-material solutions into the dispersing portion via the pipe 1, while it introduces the carrier gas into the dispersing portion via the pipe 3. The raw-material solutions and the carrier gas are introduced into the dispersing portion separately from one another, while the raw-material solutions are dispersed in the carrier gas. The dispersed raw-material solutions are sprayed into the vaporizing tube 10 via the orifice. Since the surface of the flange 11, which is positioned at the leading end of the orifice, is formed in a plane shape, the clogging of the leading end of the orifice can be suppressed. Therefore, the continuous operation time of the vaporizer for CVD can be extended.

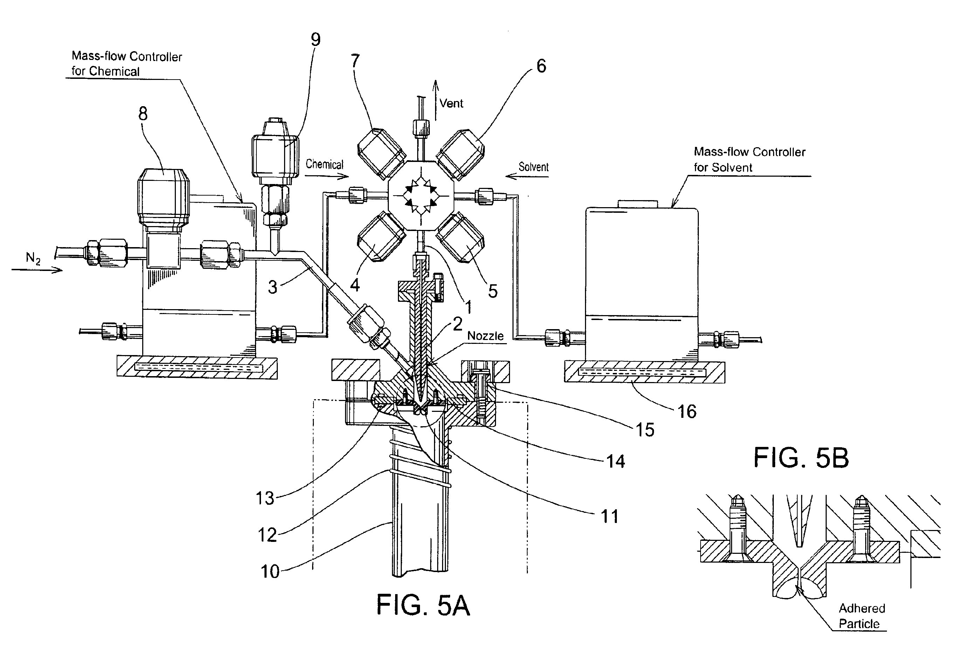

FIGS. 5A and 5B illustrate a structure of a vaporizer as a comparative example with respect to the vaporizer of this embodiment. The structure of the vaporizer of the comparative example is the same as that of this embodiment except a flange for atomization formed in a concaved shape as illustrated. It was observed that the leading end of the orifice was more likely to be clogged when the surface of the flange was formed in a concaved shape toward the base end of the orifice. The vaporizer of this embodiment is not easily clogged compared to by the comparative example.

Moreover, according to this embodiment, the carrier gas pressurized in the pipe 3 is introduced into the dispersing portion by allowing it to flow at high speed. Accordingly, temperature rises of the raw-material solutions therein can be suppressed. As a result, the clogging of the orifice can be prevented.

Further, according to this embodiment, the raw-material solutions are dispersed by dispersing portion, while the dispersed raw-material solutions in fine particulate or misty forms are heated in the inside of the vaporizing tube 10 so as to be vaporized (gasified) instantaneously. Accordingly, the clogging of the vaporization tube or the like caused by the evaporation of the solvents only in the raw-material solutions can be suppressed.

The vaporizer of this embodiment can suppress the clogging thus way, whereby it can continuously operate for long periods of time.

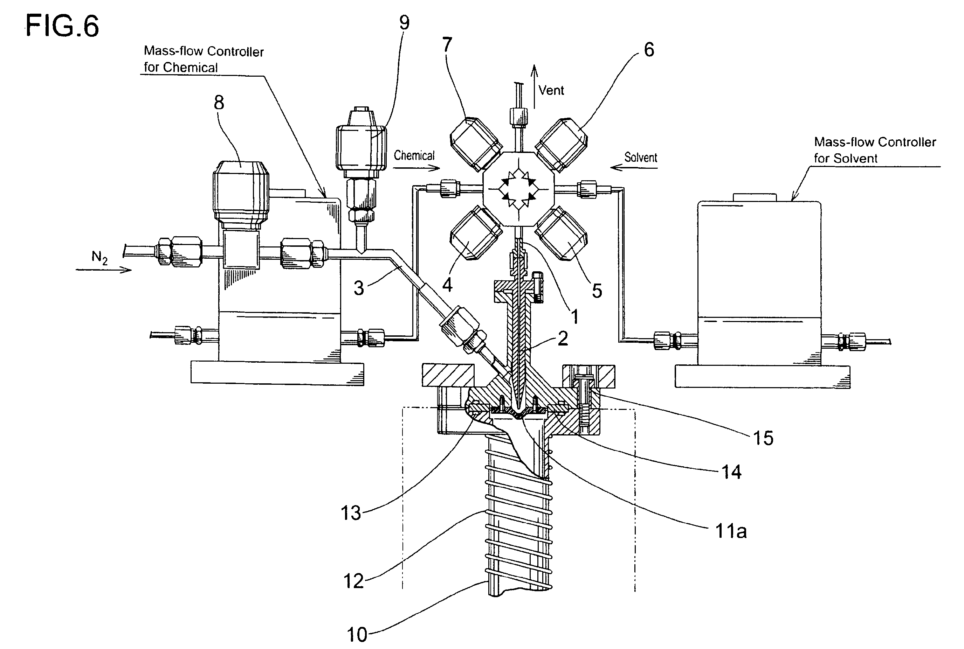

FIG. 6 schematically illustrates a structure of a vaporizer according to a fifth embodiment of the present invention. An atomizing nozzle of a convex shape is formed on a surface of a flange 11a which is positioned adjacent to the vaporizing tube 10. The water-cooling plate 16 with a water-cooling mechanism for water-cooling a mass-flow controller is not provided in this embodiment.

By forming the surface of the flange 11 a with a convex portion, it is suppressed that the leading end of the orifice is clogged when the dispersed raw-material solutions are sprayed into the vaporizing tube 10 from the leading end of the orifice. Moreover, compared to by the fourth embodiment, the continuous operation time of the vaporizer for CVD can be further extended.

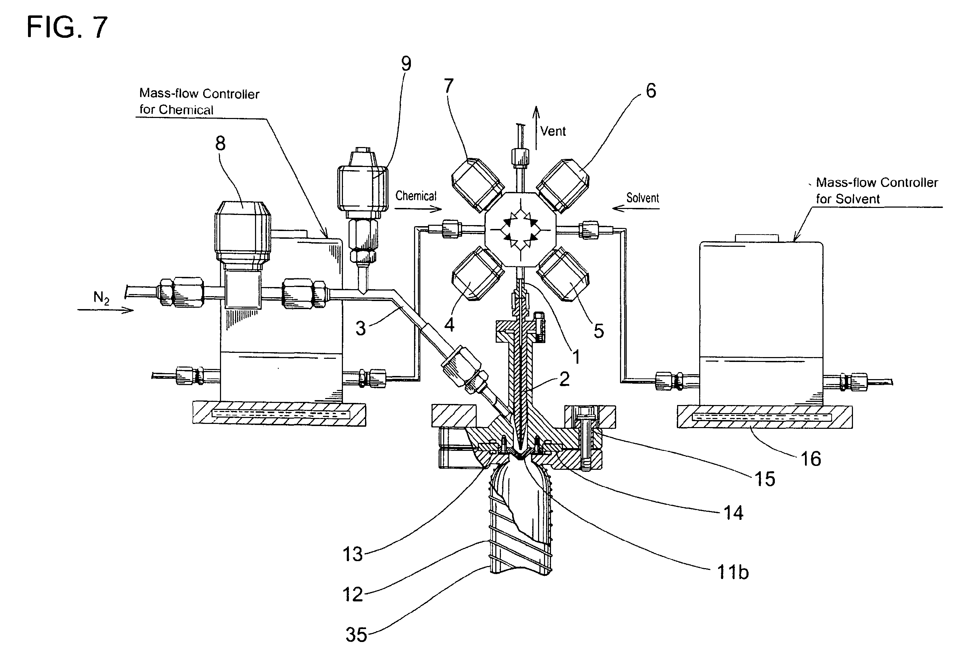

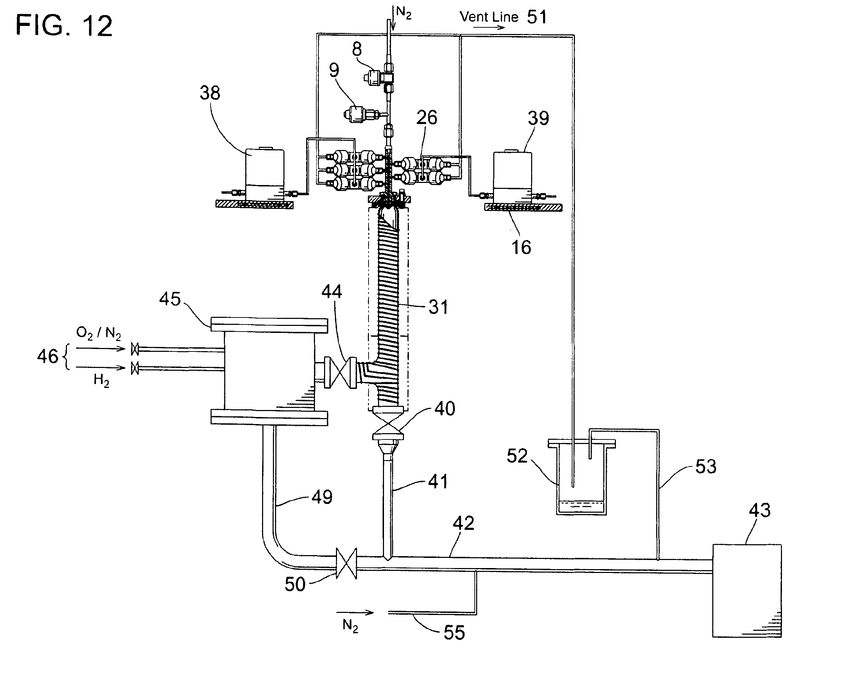

FIG. 7 schematically illustrates a structure of a vaporizer according to a sixth embodiment of the present invention. A base end of the vaporizing tube 35 is formed in a hemi-spherical shape. The heater 12 is winded up to a vicinity of a base end of the vaporizing tube 35 compared to by the one illustrated in FIG. 12. By employing this structure, the base end of the vaporizing tube 35 can be heated uniformed, while the precipitations of the solutes contained in the raw-material solutions can be more likely to be suppressed, whereby the clogging is more likely to be suppressed.

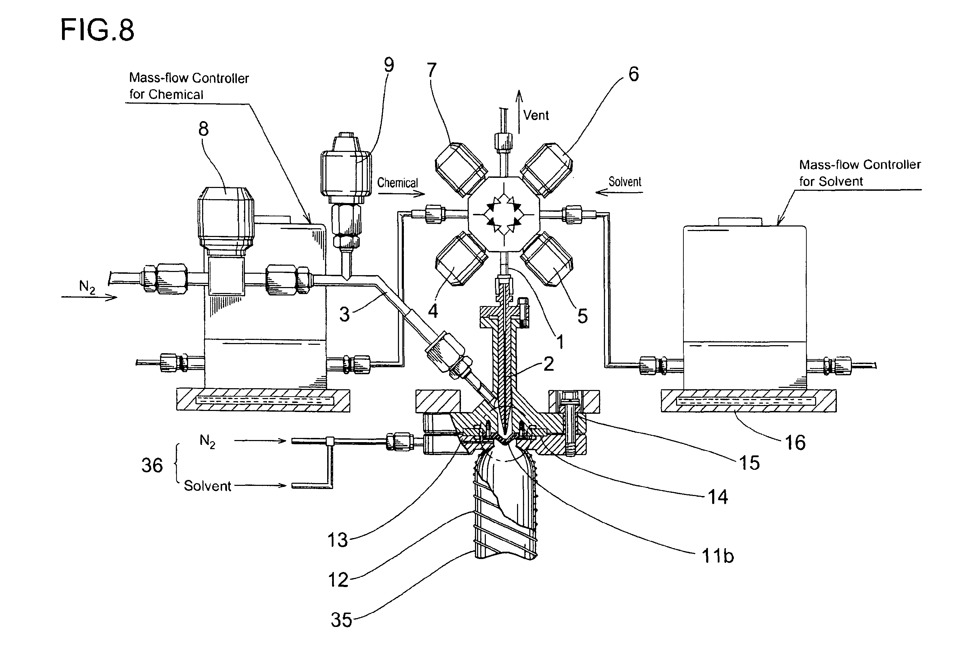

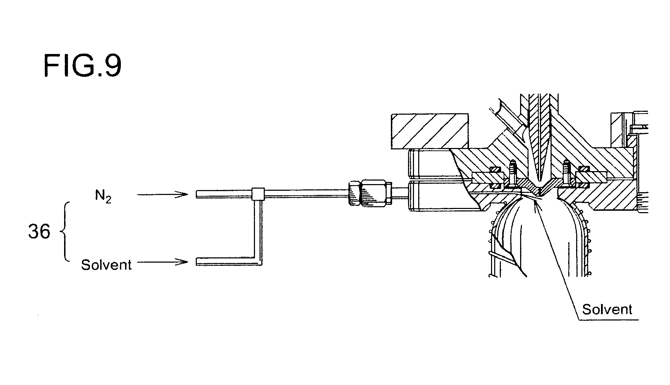

FIG. 8 schematically illustrates a structure of a vaporizer according to a seventh embodiment of the present invention, while FIG. 9 illustrates structures of the base end of a vaporizing tube of FIG. 9, an adjacent portion thereof, the tip of the nozzle and an adjacent portion thereof.

As illustrated in FIGs. 8 and 9, the vaporizing tube 35 has a cleaning mechanism 36. The cleaning mechanism 36 directly supplies a particulate flow of a cleaning solvent to the orifice in the base end of the vaporizing tube 35 and vicinity thereof. The particulate flow is one made by mixing a nitrogen gas with the solvent. When a solute of a raw-material solution adheres to the vicinity of a leading end of the orifice, it can be eliminated by the particulate flow from the cleaning mechanism 36.

Next, a cleaning carried out by the cleaning mechanism 36 will now be described.

When the raw-material solution is vaporized, a pressure of the carrier gas is constantly monitored by the pressure transducer 9. As the vaporizer is continuously operated, the orifice is gradually clogged.

As the clogging is progressed, the pressure of the carrier gas in the pipe 3 increases. A cleaning process after that the controller receives an output signal from the pressure transducer 9 and notified that the pressure of the carrier gas exceeds a predetermined value (for instance, 200K Pa) is same as that of the fourth embodiment. In addition to this cleaning process, the vaporizer of this embodiment can be carried out another cleaning process by directly supplying the nitrogen gas (carrier gas) and the solvent to the orifice and vicinity thereof by the cleaning mechanism 36. Accordingly, the solute adjacent to the leading end of the orifice can be eliminated.

Meanwhile, it is not necessary to carry out the cleaning by the cleaning mechanism 36 whenever each cleaning of the fourth embodiment is carried out. For instance, one cleaning process by the cleaning mechanism 36 may be carried out with respect to a plurality of the cleaning processes of the fourth embodiment. Moreover, the cleaning process by the cleaning mechanism 36 can be independently carried out.

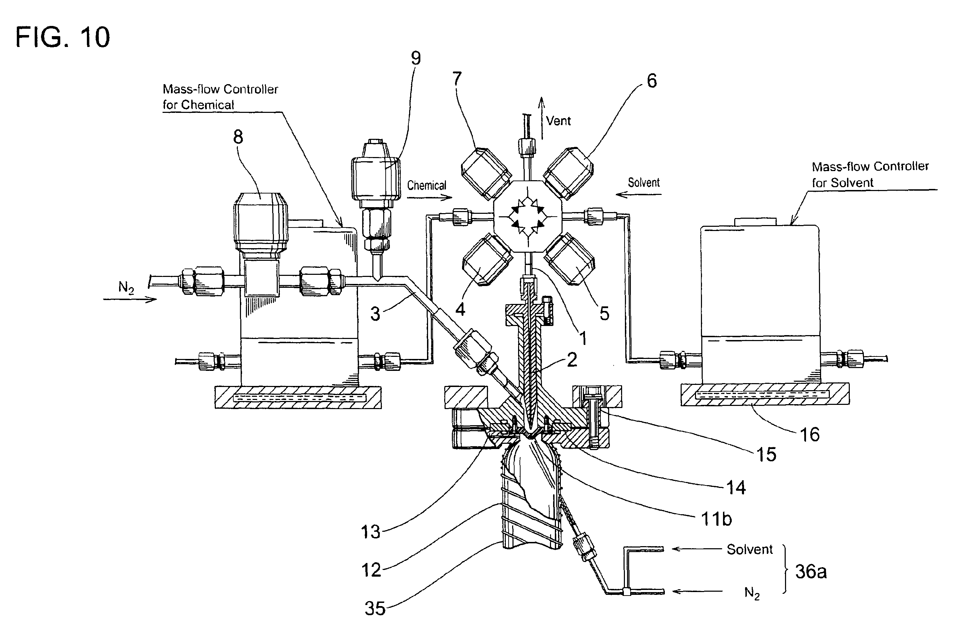

FIG. 10 schematically illustrates a structure of a vaporizer according to an eighth embodiment of the present invention. The same structure portions as those illustrated in FIGs. 8 and 9 will be denoted by the same reference numbers. A cleaning mechanism 36a directly supplies the particulate flow of the cleaning solvent from one side of the vaporizing tube 35 to the orifice in the base end of the vaporizing tube 35 and the vicinity thereof. The particulate flow is one made by mixing a nitrogen gas with the solvent. When the solute of the raw-material solution adheres to the vicinity of the leading end of the orifice, it can be eliminated by the particulate flow from the cleaning mechanism 36a.

Operations of the cleaning mechanism 36a are same as those of the seventh embodiment except that the heating of the vaporizing tube 35 is preliminary terminated so as to cool down to about room temperature.

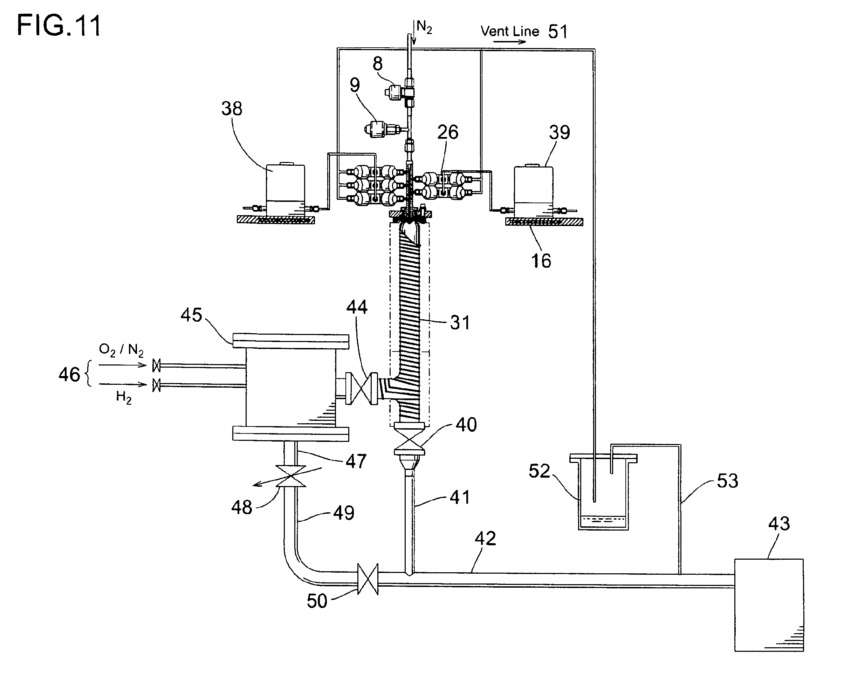

FIG. 11 schematically illustrates a structure of a solution-vaporization type CVD apparatus according to a ninth embodiment of the present invention. The CVD apparatus comprises the vaporizer of FIG. 1. Mass-flow controllers 38, 39 are provided on the water-cooling plates 16.

The leading end of the vaporizing tube 31 is connected to a vent valve 40, while the vent valve 40 is connected to a vacuum pump 43 via pipes 41, 42. Moreover, the vaporizing tube 31 is connected to a reactor chamber 45 via a gate valve 44. The reactor chamber 45 is connected to a process gas introducing mechanism 46 which introduces a process gas thereinto. Moreover, the reactor chamber 45 is connected to a reactor-pressure adjustment valve 48 via a pipe 47. The reactor-pressure adjustment valve 48 is connected a main vacuum valve 50 via a pipe 49, while the main vacuum valve 50 is connected to the vacuum pump 43 via the pipe 42.

The first to fifth block valves 26 to 30 are connected to one end of a vent line 51, respectively, while the other end of the vent line 51 is inserted into a vent line trap bottle 52. Moreover, the vent line trap bottle 52 is connected to the pipe 42 via a pipe 53.

Next, operations of the solution-vaporization CVD apparatus will now be explained in detail.

The reactor chamber 45 is subject to a temperature-rise (for instance, 600° C). After the temperature is stabilized, a substrate to be processed is put into the inside of the reactor chamber 45. Next, the vacuum pump 43 is operated, the main vacuum valve 50 and the reactor-pressure adjustment valve 48 are opened so as to depressurize the inside of the reactor chamber 45 to a predetermined degree of vacuum and remove oxygen thereinside. The process gas is introduced into the inside of the reactor chamber 45 by the process gas introducing mechanism 46, while the pressure of the inside of the reactor chamber 45 is adjusted at a predetermined value by the reactor-pressure adjustment valve 48. Next, as explained in the first embodiment, predetermined amounts of the carrier gas and the raw-material solutions are allowed to flow to the vaporizing tube 31, and vacuumed by the vacuum pump 43 via the pipes 41, 42 with the vent valve 40 opened. After flow rates of the carrier gas and raw-material solutions are stabilized, the vent valve 40 is closed, while the gate valve 44 is opened so as to introduce a reactive gas into the reactor chamber 45. Thus way, a thin film is deposited on the substrate to be processed.

After the thin film of a predetermined thickness is deposited, the vent valve 40 is opened and the gate valve 44 is closed so as to allow the reactive gas to flow to the vent, thereby terminating the deposition of the thin film. Next, the block valves 26 to 30 are operated so as to terminate the supply of the raw-material solutions (liquid organic metallic compounds) and allow the solvents to flow in the vaporizing tube 31 for one to two minutes, thereby cleaning the nozzle 32. The insides of the vaporizing tube 31 and reactor chamber 45 are cleaned by a nitrogen gas. After the cleaning, the processed substrate is taken out from the reactor chamber 45 and then next substrate is processed by the above processes. Those processes will be repeated.

FIG. 12 schematically illustrates a structure of a solution-vaporization type CVD apparatus according to a tenth embodiment of the present invention. Instead of the pipe 47 and the reactor-pressure adjustment valve 48 of FIG. 11, the CVD apparatus of this embodiment has the pipe 42 which is provided with a pipe 55 for introducing a nitrogen gas.

Next, operations of the CVD apparatus of this embodiment will now be explained.

The vent valve 40 is closed, the gate valve 44 and the main vacuum valve 50 are opened, while a nitrogen gas is introduced into the vacuum pump 43 and the pipe 42 at an appropriate amount of flow, so that an inside of the reactor chamber 45 can be adjusted at a predetermined pressure. As explained in the first embodiment, a reactive gas is introduced into the reactor chamber 45 via the vaporizing tube 31, while the process gas is introduced thereinside by the process gas introducing mechanism 46. A thin film is deposited on a substrate to be processed thus way.

After the thin film of a predetermined thickness is deposited, the gate valve 44 is closed, while the vent valve 40 is opened so as to terminate the supply of raw-material solutions and allow solvents to flow for approximately one minute. After terminating the flow of the solvents, the insides of the vaporizing tube 31 and reactor chamber 45 are cleaned by a nitrogen gas. Next substrate is processed by the above processes. Those processes will be repeated.

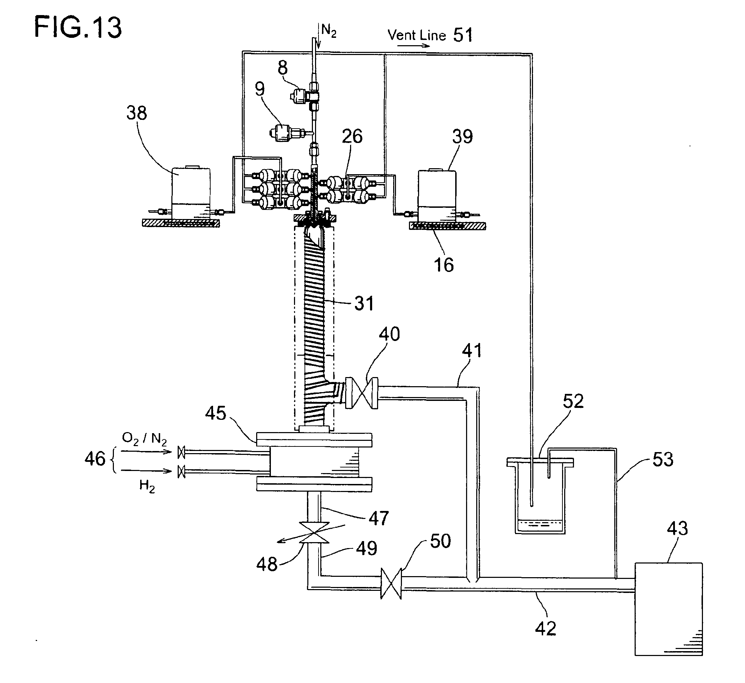

FIG. 13 schematically illustrates a structure of a solution-vaporization type CVD apparatus according to an eleventh embodiment of the present invention. The leading end of the vaporizing tube 31 is directly connected to the reactor chamber 45. Moreover, the vaporizing tube 31 is directly connected to the vent valve 40. In the CVD apparatus of the ninth embodiment, a reactive gas is introduced from one side of the reactor chamber 45, that is, a side opposite to a side introducing a process gas. In contrast, in the CVD apparatus of this embodiment, a reactive gas is introduced from a right above the reactor chamber 45. By employing this structure, the CVD apparatus of this embodiment can obtain the same effectiveness and advantages as those of the ninth embodiment.

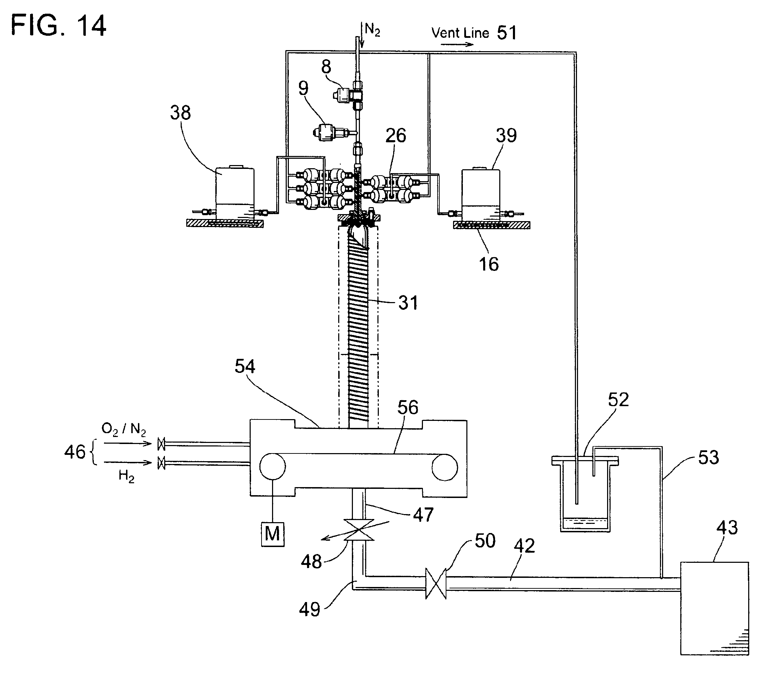

FIG. 14 schematically illustrates a structure of a solution-vaporization type CVD apparatus according to a twelfth embodiment of the present invention. The leading end of the vaporizing tube 31 is connected to a reactor chamber 54. The reactor chamber 54 is one for depositing a superconductive oxide thin film of YBCO or a thin film of Cu or the like on a substrate 56 formed in a shape like a long tape. The substrate 56 is fed from one roll, while it is rewound by another roll. A thin film can be deposited on the substrate 56 by allowing the substrate 56 to move back and forth. The reactor chamber 54 is connected to the process gas introducing mechanism 46. The reactor chamber 54 is connected to the reactor-pressure adjustment valve 48 via the pipe 47. The reactor-pressure adjustment valve 48 is connected to the main vacuum valve 50 via the pipe 49, while the main vacuum valve 50 is connected to the vacuum pump 43 via the pipe 42. Meanwhile, the CVD apparatus may be equipped with a plurality of vaporizers each having a raw-material supplying system and deposit a thin film.

Next, operations of the CVD apparatus according to this embodiment will now be explained.

The inside of the reactor chamber 54 is adjusted at a predetermined pressure by the vacuum pump 43 and the reactor-pressure adjustment valve 48 with the main vacuum valve 50 opened. A reactive gas is introduced into the reactor chamber 54 from the vaporizing tube 31, while a process gas is introduce thereinside by a process gas introducing mechanism 46. A thin film is deposited on a substrate to be processed thus way.

The CVD apparatus of this embodiment can obtain the same effectiveness and advantages as that of the ninth embodiment. Moreover, according to this embodiment, since the vaporizing tube 31 is structured that it is not provided with a valve, the CVD apparatus of this embodiment is suitable for depositing a thick film having a thickness of several µ m to several ten µ m. When a thick film is deposited, an amount of a raw-material adhering to a valve is more likely to increase. Accordingly, the CVD apparatus of this embodiment employs the structure that the vaporizing tube 31 is not provided with a valve.

## Claims

1. A solution-vaporization type CVD apparatus including a vaporizer, wherein said vaporizer comprises:
an orifice tube dispersing at least one kind of a raw-material solution in a carrier gas in a fine particulate or misty form;
at least one path for at least one kind of the raw-material solution, said at least one path supplying at least one kind of the raw-material solution to said orifice tube separately from one another;
a path for the carrier gas, said path supplying the carrier gas to the orifice tube separately from the raw-material solution;
a vaporizing member vaporizing at least one kind of the raw-material solution dispersed by said orifice tube; and
an orifice connected to said vaporizing member and said orifice tube, said orifice introducing at least one kind of the raw-material solution dispersed by said orifice tube into said vaporizing member.

2. The solution-vaporization type CVD apparatus according to claim 1, further comprising:
a monitoring mechanism for monitoring a pressure of the carrier gas; and
a cleaning mechanism for cleaning at least one of said orifice tube, said orifice and said vaporizing member in accordance with a result of a monitoring by said monitoring mechanism.

3. A solution-vaporization type CVD apparatus comprising a vaporizer, a reactor chamber connected to said vaporizer and an evacuating mechanism for evacuating said reactor chamber, wherein said vaporizer comprises:
a pipe for a carrier gas, said pipe supplying the pressurized carrier gas;
an orifice tube connected to a leading end of said pipe;
an orifice connected to a leading end of said orifice tube;
at least one pipe for at least one kind of a raw-material solution, said at least one pipe being connected to one side of said orifice tube and supplying at least one kind of the raw-material solution separately supplying from one another;
a vaporizing tube connected to said orifice and said reactor chamber; and
a heating means for heating said vaporizing tube.

4. The solution-vaporization type CVD apparatus according to claim 3, wherein:
at least one kind of the raw-material solution is mixed with the carrier gas and dispersed therein in a fine particulate or misty form in an inside of said orifice tube;
the raw-material solution dispersed in the fine particulate or misty form is introduced into said vaporizing tube via said orifice; and
the raw-material solution introduced into said vaporizing tube is heated by said heating means.

5. The solution-vaporization type CVD apparatus according to claim 3, wherein a surface of a member provided with said orifice in said vaporizing tube is formed with a convex portion.

6. A solution-vaporization type CVD apparatus comprising a vaporizer, a reactor chamber connected to said vaporizer and an evacuating mechanism for evacuating said reactor chamber, wherein said vaporizer comprises:
a pipe for a carrier gas, said pipe supplying the pressurized carrier gas;
a pipe for a raw-material solution, said pipe supplying the raw-material solution;
an orifice tube connected to said pipe for the raw-material solution;
a dispersing portion connected to said orifice tube and said pipe for the carrier gas, said dispersing portion dispersing the raw-material solution in the carrier gas in a fine particulate or misty form;
a vaporizing tube connected to said reactor chamber, said vaporizing tube vaporizing the dispersed raw-material solution;
an orifice connected to said vaporizing tube and said dispersing portion, said orifice introducing the dispersed raw-material solution into the vaporizing tube; and
a heating means for heating said vaporizing tube.

7. The solution-vaporization type CVD apparatus according to claim 6, wherein:
said orifice is formed on a flange for atomizing; and
said flange is formed with a convex portion on a surface thereof positioning in said vaporizing tube and provided with a leading end of said orifice.

8. The solution-vaporization type CVD apparatus according to claim 3, further comprising:
a monitoring mechanism for monitoring a pressure of the carrier gas in an inside of said path for the carrier gas: and
a cleaning mechanism for cleaning at least one of said orifice tube, said orifice and said vaporizing tube by supplying a solution thereto in accordance with a monitoring result of said monitoring mechanism.

9. The solution-vaporization type CVD apparatus according to claim 6, further comprising:
a monitoring mechanism for monitoring a pressure of the carrier gas in an inside of said path for the carrier gas: and
a cleaning mechanism for cleaning at least one of said orifice tube, said orifice and said vaporizing tube by supplying a solution thereto in accordance with a monitoring result of said monitoring mechanism.

10. The solution-vaporization type CVD apparatus according to claim 7, further comprising a cleaning mechanism for cleaning said convex portion of said flange with the carrier gas and a solution.

11. The solution-vaporization type CVD apparatus according to claim 3, wherein a leading end of said vaporizing tube is formed in a spherical or semispherical shape;
said orifice is connected to said leading end of said vaporizing tube; and
said heating means extends up to an end of said leading end of said vaporizing tube.

12. The solution-vaporization type CVD apparatus according to claim 6, wherein a leading end of said vaporizing tube is formed in a spherical or semispherical shape;
said orifice is connected to said leading end of said vaporizing tube; and
said heating means extends up to an end of said leading end of said vaporizing tube.

13. The solution-vaporization type CVD apparatus according to claim 3, further comprising:
a mass-flow controller for controlling a flow rate of the carrier gas or the raw-material solution; and
a cooling mechanism provided adjacent to said vaporizing tube, said cooling mechanism cooling down said mass-flow controller.

14. The solution-vaporization type CVD apparatus according to claim 6, further comprising:
a mass-flow controller for controlling a flow rate of the carrier gas or the raw-material solution; and
a cooling mechanism provided adjacent to said vaporizing tube, said cooling mechanism cooling down said mass-flow controller.

15. The solution-vaporization type CVD apparatus according to claim 3, wherein:
an other end of said vaporizing tube is connected to a first pipe via a vent valve;
said first pipe is connected to said evacuating mechanism via a second pipe;
said vaporizing tube is connected to said reactor chamber via a gate valve;
said reactor chamber is connected to a main vacuum valve via a third pipe; and
said main vacuum valve is connected to said second pipe.

16. The solution-vaporization type CVD apparatus according to claim 6, wherein:
an other end of said vaporizing tube is connected to a first pipe via a vent valve;
said first pipe is connected to said evacuating mechanism via a second pipe;
said vaporizing tube is connected to said reactor chamber via a gate valve;
said reactor chamber is connected to a main vacuum valve via a third pipe; and
said main vacuum valve is connected to said second pipe.

17. The solution-vaporization type CVD apparatus according to claim 15, further comprising a pressure adjustment valve in between said third pipe and said reactor chamber.

18. The solution-vaporization type CVD apparatus according to claim 16, further comprising a pressure adjustment valve in between said third pipe and said reactor chamber.

19. The solution-vaporization type CVD apparatus according to claim 3, wherein:
an other end of said vaporizing tube is connected to said reactor chamber;
said reactor chamber is connected to one end of a first pipe via a pressure adjustment valve;
an other end of said first pipe is connected to one end of a second pipe via a main vacuum valve; and
an other end of said second pipe is connected to said evacuating mechanism.

20. The solution-vaporization type CVD apparatus according to claim 6, wherein:
an other end of said vaporizing tube is connected to said reactor chamber;
said reactor chamber is connected to one end of a first pipe via a pressure adjustment valve;
an other end of said first pipe is connected to one end of a second pipe via a main vacuum valve; and
an other end of said second pipe is connected to said evacuating mechanism.
